# DEMANDE DE BREVET EUROPEEN

(11) **EP 3 492 893 A1**
(43) Date de publication de la demande: **05.06.2019**
(21) Numéro de dépôt: 18209881.4
(22) Date de dépôt: 03.12.2018
(51) Int. Cl.: G01J 5/34

(54) **CAPTEUR DE MOTIF THERMIQUE A CAPACITE PYROELECTRIQUE ET COUCHE DE PROTECTION DURE**

(30) Priorité: 04.12.2017 FR 1761601
(71) Demandeur: Commissariat à l'énergie atomique et aux énergies alternatives, 75015 Paris (FR)
(72) Inventeur: BENWADIH, Mohammed, 94500 CHAMPIGNY SUR MARNE (FR); SERBUTOVIEZ, Christophe, 38500 VOIRON (FR)
(74) Mandataire: Brevalex

(57) **Abrégé**

Capteur (100) de motif thermique comportant plusieurs pixels (102) disposés sur un substrat (104), chaque pixel comprenant au moins :
- une capacité pyroélectrique formée par au moins une portion (106) de matériau pyroélectrique disposée entre au moins une électrode inférieure (108) et au moins une électrode supérieure (110), avec l'électrode inférieure disposée entre le substrat et la portion de matériau pyroélectrique,
- une couche diélectrique (112) telle que l'électrode supérieure soit disposée entre la portion de matériau pyroélectrique et la couche diélectrique,
- un élément chauffant (114) comprenant au moins un dépôt de particules électriquement conductrices et tel que la couche diélectrique soit disposée entre l'électrode supérieure et l'élément chauffant,
- une couche de protection (200) disposée entre la couche diélectrique et l'élément chauffant et comprenant au moins un matériau dont la dureté Shore A est supérieure ou égale à environ 60.

## Description

### DOMAINE TECHNIQUE ET ART ANTÉRIEUR

L'invention se rapporte à un capteur de motif thermique exploitant les propriétés de pyroélectricité d'un matériau, et formant avantageusement un capteur d'empreinte digitale.

La détection d'empreinte digitale peut être réalisée par des capteurs dits « passifs » exploitant une différence de températures entre celle du doigt et celle du capteur, comme décrit dans les documents US 4 394 773, US 4 429 413 et US 6 289 114. Au niveau des crêtes de l'empreinte, la peau du doigt est en contact physique direct avec le capteur. Un transfert thermique entre la peau et la surface de contact du capteur s'effectue par conduction, ce qui conduit à une première variation temporelle de température. Au niveau des vallées de l'empreinte, la peau du doigt n'est pas en contact physique direct avec le capteur. Un transfert thermique entre la peau et la surface de contact du capteur s'effectue à travers l'air qui est plutôt un isolant thermique, ce qui conduit à une seconde variation temporelle de température, moins importante. La différence entre ces deux variations temporelles de température se traduit par une différence entre des signaux mesurés par les capacités pyroélectriques, selon qu'elles se trouvent sous une vallée ou sous une crête de l'empreinte. L'image de l'empreinte présente donc un contraste qui dépend de cette différence.

Cependant, ces capteurs ont pour inconvénient de réaliser une mesure qui dépend uniquement de la différence entre la température du doigt et la température du capteur. Ainsi, après quelques secondes de contact entre le doigt et le capteur, la température du doigt et la température de la surface de contact du capteur s'homogénéisent, et il n'est plus possible d'obtenir un contraste satisfaisant. Il peut également arriver que le niveau du signal obtenu soit nul lorsque le doigt et le capteur sont à la même température, ou encore que le contraste des images capturées varie, ce qui pose alors des problèmes lors du traitement ultérieur des images obtenues (par exemple, une inversion des températures entraîne une inversion de l'image obtenue).

Un autre type de capteur, de type actif, offre une solution à ce problème grâce à l'ajout d'éléments chauffants sous la surface de contact du capteur. Un tel capteur est décrit par exemple dans la demande de brevet EP 2 385 486 A1. Les éléments chauffants dissipent une certaine quantité de chaleur dans chaque pixel du capteur et l'échauffement des pixels est mesuré au bout d'un certain temps. La variation de température obtenue est donc importante au niveau des vallées de l'empreinte, où la chaleur est transférée au doigt à travers l'air, et plus faible au niveau des crêtes de l'empreinte, où la chaleur est transférée directement au doigt, par conduction. Cela conduit à une température finale plus faible dans le cas d'un pixel en présence d'une crête de l'empreinte, où la chaleur est absorbée par la peau, par rapport à un pixel en présence d'une vallée de l'empreinte où la chaleur est plutôt conservée dans le pixel. Cela permet d'améliorer et de conserver au cours du temps, le contraste d'une image acquise à l'aide dudit capteur.

Les éléments décrits ci-dessus pour la détection d'empreinte digitale s'appliquent également à la détection d'un motif thermique autre qu'une empreinte digitale, l'élément dont le motif thermique à détecter étant disposé sur le capteur lors de la mesure.

Un capteur de motif thermique comporte des moyens de détection thermique qui peuvent être des éléments pyroélectriques, des diodes, des thermistances ou tout autre élément sensible à la température permettant de convertir une variation de température en une variation de potentiel ou de courant électrique.

Plus particulièrement, un capteur de type pyroélectrique comporte une matrice de capacités pyroélectriques disposées sur un substrat, par exemple en verre.

Chaque capacité pyroélectrique comporte une couche en matériau pyroélectrique, disposée entre une électrode inférieure et une électrode supérieure. Une de ces deux électrodes est portée à un potentiel constant, et forme une électrode de référence. L'autre électrode collecte des charges pyroélectriques, générées par le matériau pyroélectrique en réponse à une variation de température. L'électrode supérieure est recouverte d'une couche de protection sur laquelle l'élément dont le motif thermique est mesuré, par exemple un doigt, est destiné à être disposé lors de la mesure.

Le matériau pyroélectrique peut être par exemple un poly(fluorure de vinylidène-trifluoroéthylène) ou P(VDF-TrFE) ou encore PVDF (polyfluorure de vinylidène), une céramique telle que du PZT (titano-zirconate de plomb, ou « Lead Zirconate Titanate » en anglais), de l'AIN, du BaTiO₃ ou encore du ZnO. D'autres matériaux pyroélectriques sont possibles, à savoir tous ceux qui produisent des charges électriques en fonction d'un paramètre pyroélectrique.

Dans le cas d'un capteur thermique actif, le capteur est également muni d'un élément chauffant. Cet élément chauffant est par exemple réalisé sous la forme d'un serpentin entourant partiellement les électrodes supérieures et permettant de chauffer latéralement les capacités pyroélectriques, au niveau des électrodes supérieures.

Chaque capacité pyroélectrique forme un transducteur qui traduit une variation temporelle de température en un signal électrique tel qu'une différence de potentiels électriques.

Lorsque le capteur doit avoir une surface importante et être réalisé avec un faible coût, il est avantageusement réalisé en technologie dite imprimée, ou par impression, moins onéreuse que la lithographie sur semi-conducteur. Différentes portions de matériaux formant les éléments des pixels du capteur peuvent dans ce cas être réalisées avec des encres suffisamment stables pour ne pas nécessiter d'encapsulation très performante. La réalisation d'au moins une partie des éléments du capteur est envisageable par impression, par exemple sur des substrats plastiques simples.

Un tel capteur réalisé par dépôts par impression comporte une ou plusieurs portions électriquement conductrices (électrode(s) et/ou élément chauffant) réalisées par dépôt d'encre comportant des particules conductrices, par exemple d'argent, qui forment, après évaporation du solvant, la ou les portions électriquement conductrices. Ces particules peuvent avoir des formes géométriques avec des angles saillants qui peuvent détériorer le capteur lorsque le doigt, ou plus généralement l'élément dont le motif thermique est destiné à être capturé, est disposé sur le capteur. Outre ces angles saillants, le capteur peut également être détérioré par les rugosités formées par ces portions électriquement conductrices réalisées par dépôts d'encres conductrices, cette rugosité étant par exemple de l'ordre de 1,5 µm RMS et due aux inhomogénéités des dépôts ainsi qu'à la forme des particules. Par exemple, un capteur peut comporter, pour chaque pixel, une capacité pyroélectrique, une couche diélectrique disposée sur la capacité pyroélectrique, une portion conductrice formant l'élément chauffant du pixel et qui est disposée sur la couche diélectrique, et une couche de protection surfacique recouvrant l'élément chauffant et sur laquelle le doigt est destiné à être disposé lors d'une capture d'empreinte. La portion conductrice formant l'élément chauffant peut être réalisée par impression d'une encre comportant des particules d'argent. Lorsque le doigt appuie sur le capteur, les particules d'argent et/ou les rugosités de la portion conductrice formant l'élément chauffant peuvent percer la couche diélectrique sur laquelle se trouve cette portion conductrice, et ainsi endommager la capacité pyroélectrique se trouvant sous la couche diélectrique. En perçant la couche diélectrique, des chemins de conduction peuvent être créés entre les portions conductrices formant les éléments chauffants et les électrodes supérieures des capacités pyroélectriques des pixels, engendrant des courants de fuite importants au sein des pixels, ce qui empêche le bon fonctionnement du dispositif. Dans le cas de particules de tailles importantes, il est même possible d'aboutir à une détérioration totale du capteur, le rendant non fonctionnel.

### EXPOSÉ DE L'INVENTION

Un but de la présente invention est de proposer un capteur de motif thermique dans lequel les risques de dégradation du capteur dus aux portions conductrices formant les éléments chauffants et comportant des dépôts de particules électriquement conductrices sont réduits ou supprimés.

Pour cela, la présente invention propose un capteur de motif thermique comportant plusieurs pixels disposés sur un substrat, chaque pixel comprenant au moins :
- une capacité pyroélectrique formée par au moins une portion de matériau pyroélectrique disposée entre au moins une électrode inférieure et au moins une électrode supérieure, avec l'électrode inférieure disposée entre le substrat et la portion de matériau pyroélectrique,
- une couche diélectrique telle que l'électrode supérieure soit disposée entre la portion de matériau pyroélectrique et la couche diélectrique,
- un élément chauffant comprenant au moins un dépôt de particules électriquement conductrices et tel que la couche diélectrique soit disposée entre l'électrode supérieure et l'élément chauffant,
- une couche de protection disposée entre la couche diélectrique et l'élément chauffant et comprenant au moins un matériau dont la dureté Shore A est supérieure ou égale à environ 60.

Avec la présence d'une telle couche de protection dure interposée entre la couche diélectrique et l'élément chauffant, un appui, par exemple par le doigt dont l'empreinte est destinée à être capturée, sur le capteur n'entraîne pas de dégradation au sein des pixels, et cela même si l'élément chauffant est formé par un dépôt de particules électriquement conductrices ayant des angles saillants et/ou ayant une certaine rugosité. En évitant que les particules électriquement conductrices du dépôt formant l'élément chauffant ne percent la couche diélectrique qui recouvre l'électrode supérieure, l'intégrité des pixels du capteur est préservée et la création de courants de fuite importants au sein des pixels est évitée.

La couche diélectrique peut avoir une dureté Shore A inférieure à 60, ou une dureté inférieure à 3H mesurée par la mise en oeuvre d'un test de dureté à la rayure.

La dureté du matériau de la couche de protection peut être mesurée par un duromètre Shore, conformément à l'une des normes ISO 868 et 7619, ASTM D 2240 et DIN 53505.

De manière alternative, la valeur de la dureté du matériau de la couche de protection peut être définie comme étant supérieure ou égale à 3H, mesurée par la mise en oeuvre d'un test de dureté à la rayure conforme à la norme ISO 15184:2012.

Les électrodes inférieure et supérieure et la portion de matériau pyroélectrique peuvent former un empilement disposé sur le substrat.

La couche diélectrique et la couche de protection correspondent à deux couches distinctes.

L'épaisseur de la couche de protection peut être comprise entre environ 100 nm et 600 nm. Avec une telle épaisseur, la couche de protection offre une bonne protection mécanique de la couche diélectrique tout en réduisant son impact sur le transfert thermique entre la capacité pyroélectrique et l'élément dont le motif thermique est destiné à être capturé.

Le matériau de la couche de protection peut être réticulable et présenter des liaisons covalentes entre les atomes de ce matériau.

La couche de protection peut comporter au moins un matériau polymère organique réticulable et/ou au moins un matériau inorganique de type sol-gel et/ou du SOG (« Spin-On-Glass ») et/ou un matériau céramique de type sol-gel (un matériau organométallique qui, après recuit, crée un réseau semblable à un réseau obtenu par réticulation).

Le SOG peut correspondre au matériau obtenu après un recuit d'une solution liquide contenant du siloxane ou du silicate dans un solvant tel qu'un alcool.

Un matériau de type sol-gel peut être obtenu à partir de précurseurs organométalliques tels que de l'alcoxyde métallique de silicium ou de titane, se trouvant dans des solutions organiques, permettant d'obtenir du SiO₂ ou du TiO₂.

Le matériau polymère organique réticulable peut correspondre à l'un des matériaux suivants : époxy, polyuréthane, acrylique, et/ou le SOG peut correspondre à l'un des matériaux suivants : PMMSQ, MSQ, polyquinoxaline, et/ou le matériau inorganique de type sol-gel peut comporter au moins l'un des composés suivants : Al₂O₃, TiO₂, WO₃, SiO₂.

L'élément chauffant peut comporter au moins une couche de particules d'argent. En raison des angles saillants des particules d'argent, la couche de protection est particulièrement utile en présence d'un tel élément chauffant.

Le capteur peut être tel que :
- le substrat comprend au moins un matériau plastique, et/ou
- les électrodes inférieure et supérieure comportent au moins l'un des matériaux suivants : argent, or, cuivre, nickel, carbone, graphène, polymère conducteur.

De tels matériaux sont adaptés pour une réalisation au moins partielle du capteur de motif thermique par impression.

Un dépôt par impression correspond par exemple à la réalisation d'un dépôt de matériau par au moins l'une des techniques suivantes : sérigraphie, héliogravure, jet d'encre, flexographie, ou encore gravure offset.

De manière avantageuse, le capteur de motif thermique peut être un capteur d'empreinte digitale.

L'invention concerne également un procédé de réalisation d'un capteur de motif thermique comportant plusieurs pixels disposés sur un substrat, chacun réalisé par la mise en oeuvre des étapes suivantes :
- réalisation d'au moins une électrode inférieure sur le substrat ;
- réalisation d'au moins une portion de matériau pyroélectrique au moins sur l'électrode inférieure;
- réalisation d'au moins une électrode supérieure sur la portion de matériau pyroélectrique ;
- réalisation d'au moins une couche diélectrique au moins sur l'électrode supérieure ;
- réalisation d'au moins une couche de protection sur la couche diélectrique ;
- réalisation d'au moins un élément chauffant sur la couche de protection ;
dans lequel l'électrode inférieure, l'électrode supérieure et la portion de matériau pyroélectrique forment une capacité pyroélectrique, et dans lequel la couche de protection comporte au moins un matériau dont la dureté Shore A est supérieure ou égale à environ 60.

La réalisation de l'élément chauffant peut comporter un dépôt de particules électriquement conductrices.

L'élément chauffant peut comporter au moins une couche de particules d'argent formée par un dépôt par impression.

L'électrode inférieure et/ou l'électrode supérieure et/ou la portion de matériau pyroélectrique peuvent être réalisées par des dépôts par impression.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

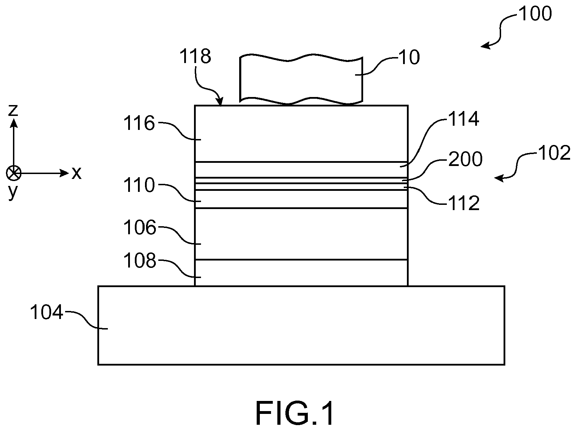

- la figure 1 représente, de manière schématique, une vue en coupe d'un pixel d'un capteur de motif thermique, selon un mode de réalisation particulier de l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère à la figure 1 qui représente une vue en coupe d'un pixel 102 d'un capteur de motif thermique 100 selon un mode de réalisation particulier.

Le pixel 102 est réalisé sur un substrat 104. Le substrat 104 est ici un substrat souple à base de matériau plastique, comprenant par exemple du polyimide et/ou du PEN (poly(naphtalate d'éthylène)) et/ou du PET (poly(téréphtalate d'éthylène)), sur lequel les différents éléments du capteur 100 (capacités pyroélectriques des pixels 102, transistors en couches minces ou TFT pour « Thin Film Transistor » dans le cas d'un capteur 100 avec une matrice active, etc.), sont réalisés en technologie imprimée.

L'épaisseur du substrat 104 (dimension selon l'axe Z représenté sur la figure 1) est par exemple égale à environ 125 µm ou plus généralement comprise entre environ 50 µm et 250 µm.

Un seul pixel 102 est représenté sur la figure 1, pour plus de lisibilité, mais le capteur de motif thermique 100 comporte une pluralité de pixels 102 réalisés sur le substrat 104. Les pixels 102 du capteur de motif thermique 100 sont ici disposés en formant une matrice de plusieurs lignes et plusieurs colonnes de pixels 102. Le pas des pixels 102 (distance entre les centres de deux pixels 102 voisins), dans le plan (X,Y) (c'est-à-dire le plan du substrat 104), est par exemple compris entre environ 50 µm et plusieurs centimètres. Dans le cas d'un capteur de résolution égale à 500 dpi (« dot per inch »), le pas des pixels 102 est égal à 50,8 µm.

Chacun des pixels 102 du capteur de motif thermique 100 comporte des moyens de mesure, ou de détection, thermique formés par une capacité pyroélectrique. Chaque capacité pyroélectrique comporte une portion de matériau pyroélectrique 106 disposée entre une électrode inférieure 108 et une électrode supérieure 110.

Le matériau pyroélectrique de la portion 106 est ici un copolymère, avantageusement du P(VDF-TrFE) et/ou du PVDF. En variante, la portion 106 peut comporter de l'AIN et/ou du PZT et/ou tout autre matériau pyroélectrique adapté pour former une capacité pyroélectrique. L'épaisseur de la portion 106 (dimension selon l'axe Z représenté sur la figure 1) est par exemple égale à environ 3 µm, et par exemple comprise entre environ 2 et 10 µm. De manière générale, le matériau pyroélectrique de la portion 106 est un matériau organique qui, en technologie imprimée, est non réticulable.

L'électrode inférieure 108 et l'électrode supérieure 110 comportent chacune au moins un matériau électriquement conducteur. Les électrodes 108, 110 peuvent comporter de l'argent, de l'or, du cuivre, du nickel, du carbone, du graphène ou encore un polymère conducteur tel que du PEDOT:PSS (poly(3,4-éthylènedioxythiophène). L'épaisseur de chacune des électrodes 108, 110 est par exemple comprise entre environ 0,01 µm et 1 µm. L'épaisseur de chacune des électrodes 108, 110 peut être plus importante et être comprise entre environ 0,01 µm et 3 µm.

L'électrode supérieure 110 et/ou l'électrode inférieure 108 sont réalisées par exemple sous la forme de lignes métalliques parallèles les unes aux autres. Ainsi, les électrodes inférieures 108 et/ou les électrodes supérieures 110 sont par exemple réalisées sous la forme de lignes ayant chacune une largeur égale à environ 40 µm et espacées les unes des autres d'une distance égale à environ 40 µm.

L'une des électrodes supérieure et inférieure 108, 110, ici l'électrode supérieure 110, est destinée à être reliée à une potentiel électrique de référence et sert également de plan de masse dans le capteur 100. L'autre électrode, c'est-à-dire ici l'électrode inférieure 108, est destinée à recevoir les charges électriques générées lors de la mesure du motif thermique par le capteur 100.

L'électrode supérieure 110 est recouverte par une couche diélectrique 112. L'épaisseur de la couche diélectrique 112 va par exemple de 0,1 µm à 5 µm, et est de préférence égale à environ 1 µm. La couche diélectrique 112 est, par exemple, en polyimide.

Dans le mode de réalisation où le capteur de motif thermique 100 est apte à réaliser une détection thermique active, en plus des éléments précédemment décrits, le capteur 100 comporte également des éléments chauffants 114 dissipant une certaine quantité de chaleur dans les pixels 102, et notamment dans le matériau pyroélectrique de la portion 106. Le ou les matériaux servant à la réalisation du ou des éléments chauffants 114 de chaque pixel 102 peuvent être similaires à ceux mentionnés précédemment pour la réalisation des électrodes 108, 110. Les éléments chauffants 114 sont, par exemple, réalisés sous la forme de lignes métalliques parallèles les unes aux autres.

Les éléments chauffants 114 ont, par exemple, une épaisseur allant de 0,03 µm à 10 µm, et de préférence allant de 0,2 µm à 1 µm.

Chacun des éléments chauffants 114 forme un élément métallique résistif (résistance électrique par exemple comprise entre environ 10 Ω et 100 Ω) associé à un pixel 102 et qui permet de chauffer ce pixel 102. Les éléments chauffants 114 permettent, lors d'une détection mise en oeuvre par le capteur 100, de dissiper une certaine quantité de chaleur dans les pixels 102, et notamment dans le matériau pyroélectrique de la portion 106. Dans chaque pixel 102, le chauffage de la portion 106 de matériau pyroélectrique est obtenu en faisant circuler un courant dans l'élément chauffant 114 formant la résistance de chauffage de chacun des pixels 102. Afin d'obtenir une bonne sensibilité à la détection, traduisant une forte différence de températures entre un pixel en contact avec une crête de l'empreinte et un pixel en contact avec une vallée de l'empreinte, les puissances électriques injectées par les éléments chauffants 114 peuvent aller de 0,5 mW/pixel à 5 mW/pixel dans le cas de pixels ayant des côtés de dimension égale à environ 50 µm (comme c'est le cas pour un capteur d'empreinte digitale standard de résolution égale à 500 dpi).

Du fait que l'élément chauffant 114 est formé par un dépôt de particules conductrices obtenu par exemple à partir d'une encre déposée par impression, la capacité pyroélectrique du pixel 102 est ici protégée mécaniquement vis-à-vis des particules conductrices formant de l'élément chauffant 114 par une couche de protection 200 interposée entre l'élément chauffant 114 et la couche diélectrique 112.

Cette protection mécanique est conférée par la dureté du matériau de la couche de protection 200. Ce matériau a une dureté Shore A supérieure ou égale à environ 60. Il est également possible de qualifier la dureté de ce matériau en mettant en oeuvre un test de résistance à la rayure, cette dureté étant supérieure ou égale à la valeur 3H.

Le matériau de la couche de protection 200 est ici un matériau polymère organique réticulable. En variante, il est possible que le matériau de la couche de protection 200 soit un matériau inorganique de type SOG ou SolGel durcit après la mise en oeuvre d'un recuit thermique. Pour améliorer la dureté de tels matériaux inorganiques, un autre recuit peut être mis en oeuvre, par exemple avec une lampe impulsionnelle de type UV Flash de longueur d'onde égale à environ 190 nm ou bien en utilisant un laser à excimère de longueur d'onde égale à environ 248 nm.

De plus, l'épaisseur de la couche de protection 200 est par exemple comprise entre environ 50 nm et 1 µm, et de préférence comprise entre environ 100 nm et 600 nm. L'épaisseur de la couche de protection 200 est de préférence inférieure à environ 600 nm afin de limiter son impact sur le chauffage réalisé par l'élément chauffant 114, c'est-à-dire limiter l'absorption, par la couche de protection, de la chaleur générée par l'élément chauffant 114. L'épaisseur de la couche de protection 200 est de préférence supérieure à environ 100 nm afin de conférer une très bonne protection mécanique de la couche diélectrique 112 vis-à-vis de l'élément chauffant 114.

La couche de protection 200 comporte par exemple un ou plusieurs matériaux polymères organiques réticulables comme par exemple : époxy, polyuréthane, acrylique. En variante, le matériau de la couche de protection 200 peut être de type SOG (Spin-On-Glass) tel que du PMMSQ ou MSQ (méthylsilsesquiexane), polyquinoxaline, céramique sol-gel.

Lorsque la couche de protection 200 comporte de tels matériaux polymères organiques, au moins un agent réticulant sensible aux UV et/ou à la chaleur peut être utilisé lors de l'élaboration de la couche de protection 200.

La couche de protection 200 peut également comporter un ou plusieurs matériaux inorganiques obtenus par procédé de type sol-gel, tels que des oxydes métalliques, comme par exemple : Al₂O₃, TiO₂, WO₃, ou bien du SiO₂.

Les éléments chauffants 114 ainsi que les parties de la couche de protection 200 sur lesquelles les éléments chauffants 114 ne sont pas présents sont recouverts par une couche d'encapsulation 116, correspondant par exemple à une couche laminée de PET ou de tout autre matériau adapté à la réalisation de cette couche 116. D'autres matériaux sont envisageables pour cette couche 116, comme par exemple du polyimide, du PVDF et/ou ses copolymères, du PMMA, etc. Le ou les matériaux utilisés ainsi que l'épaisseur de la couche 116 sont choisis pour obtenir un bon transfert de la chaleur depuis une face avant 118 du capteur 100 vers les capacités pyroélectriques des pixels 102. Ainsi, la couche d'encapsulation 116 est réalisée telle qu'elle ne soit ni trop thermiquement résistive (car la chaleur ne la traverserait pas), ni trop thermiquement conductrice (car la chaleur partirait dans ce cas sur les côtés, vers les autres pixels, provoquant de la diathermie au sein du capteur 100), ni trop épaisse (pour avoir un transfert de chaleur s'opérant depuis la face avant 118 du capteur 100 vers la capacité pyroélectrique), ni trop fine (l'épaisseur de la couche 116 doit tout de même être suffisante pour que son rôle de protection soit rempli). L'épaisseur de la couche d'encapsulation 116 peut aller d'environ 1 micron à environ 10 µm, et est par exemple comprise entre environ 3 µm et 5 µm, par exemple égale à environ 4 µm. De manière alternative, la couche d'encapsulation 116 peut correspondre à une couche de DLC (« Diamond Like Carbon ») d'épaisseur inférieure à environ 1 µm.

La face supérieure 118 de la couche d'encapsulation 116 correspond à la surface sur laquelle se trouve l'élément dont le motif thermique est destiné à être détecté, par exemple un doigt dont l'empreinte est destinée à être détectée. Sur la figure 1, la référence 10 désigne le doigt présent sur le capteur 100.

Selon une configuration avantageuse du capteur 100, les électrodes inférieures 108 sont réalisées sous la forme de lignes conductrices parallèles entre elles et orientées selon une première direction, les électrodes supérieures 110 sont réalisées sous la forme d'une couche conductrice servant également de plan de masse, et les éléments chauffants 114 sont réalisés sous la forme de lignes conductrices parallèles entre elles et orientées selon une deuxième direction sensiblement perpendiculaire à la première direction. Vu de dessus, les intersections entre les lignes formant les électrodes inférieures 108 et celles formant les éléments chauffants 114 correspondent aux pixels 102, c'est à dire aux zones de détection par le matériau pyroélectrique des portions 106.

Le tableau ci-dessous donne un exemple de réalisation avantageux d'un pixel 102 du capteur de motif thermique 100.

| | **MATERIAU** | **EPAISSEUR** |
|---|---|---|
| **Couche d'encapsulation 116** | PET | Entre 3 µm et 10 µm |
| **Elément chauffant 114** | Ag | 1 µm |
| **Couche de protection 200** | MSQ | 600 nm |
| **Couche diélectrique 112** | Polyimide | Entre 0,2 µm et 1 µm |
| **Electrode supérieure 110** | PEDOT:PSS ou Ag | Entre 0,6 µm et 1 µm |
| **Portion pyroélectrique 106** | PVDF-TrFE | Entre 2 µm et 3 µm |
| **Electrode inférieure 108** | Au | 0,03 µm |
| **Substrat 104** | PEN | 125 µm |

Le MSQ indiqué dans le tableau ci-dessus correspond par exemple au produit nommé LKD-5109 et commercialisé par la société JSR© et qui forme un matériau diélectrique low-k (permittivité diélectrique inférieure à environ 3,9) poreux.

Le capteur de motif thermique 100 décrit ci-dessus correspond à un capteur réalisé en technologie dite imprimée, c'est-à-dire dans lequel au moins une partie des différents éléments présents sur le substrat 104 sont déposés par la mise en oeuvre de techniques d'impression : sérigraphie, héliogravure, jet d'encre, flexographie, ou encore gravure offset, et faisant appel à des encres compatibles avec ces techniques de dépôt. Le capteur 100 comporte ici au moins les éléments chauffants 114 réalisés par dépôt de type impression.

Un exemple de procédé de fabrication du capteur de motif thermique 100 est décrit ci-dessous.

Le capteur est réalisé à partir du substrat 104. Le matériau du substrat 104 (verre, semi-conducteur, plastique, etc.) est choisi selon la technologie avec laquelle les différents éléments du capteur 100 sont réalisés. Le substrat 104 est tout d'abord nettoyé afin d'éliminer les résidus organiques présents sur celui-ci. Le type de nettoyage mis en oeuvre est fonction du matériau du substrat 104.

La deuxième étape consiste à former sur la face avant 118 du substrat 104 les électrodes inférieures 108 par impression d'une encre électriquement conductrice (par exemple sérigraphie, pulvérisation (« spray » en anglais) ou par jet d'encre). En variante, les électrodes inférieures 108 peuvent être formées par un dépôt d'une première couche électriquement conductrice, par exemple métallique, à partir de laquelle les électrodes inférieure 108 sont réalisées par photolithographie et gravure de cette première couche. Par exemple, pour la réalisation d'électrodes inférieures 108 comportant de l'or, ces électrodes inférieures 108 sont formées en réalisant un dépôt d'une couche d'or ayant une épaisseur par exemple égale à environ 30 nm, cette couche étant ensuite soumise à une photolithographie puis gravée pour former les électrodes inférieures 108.

Le matériau pyroélectrique formant les portions 106 est ensuite déposé par impression sur les électrodes inférieures 108. En technologie non imprimée, les portions 106 sont définies par la mise en oeuvre d'une photolithographie et d'une gravure d'une couche de matériau pyroélectrique. Lorsque la gravure mise en oeuvre correspond à une gravure plasma, un plasma O₂ peut être utilisé seul ou en combinaison avec du SF₆ (hexafluorure de soufre). Les portions de matériau pyroélectrique conservées après la mise en oeuvre de cette gravure correspondent aux portions 106 du matériau pyroélectrique localisées au niveau des pixels 102 du capteur 100.

Les électrodes supérieures 110 sont ensuite déposées, par exemple par impression, comme précédemment décrit.

La couche diélectrique 112 est ensuite déposée sur les électrodes supérieures 110 et les parties de matériau pyroélectrique non recouvertes par les électrodes supérieures 110.

Le matériau de la couche de protection 200 est ensuite déposé sur la couche diélectrique 112, puis réticulé afin de former la couche de protection 200. La technique mise en oeuvre pour former la couche de protection 200 est fonction de la nature du matériau utilisé pour former cette couche.

Par exemple, une couche de protection 200 comprenant du MSQ peut être réalisée en déposant par sérigraphie une couche de LKD 5109 commercialisé par la société JSR© avec une épaisseur égale à environ 600 nm. Un premier recuit de la couche déposée peut être mis en oeuvre sur une plaque chauffante, à une température égale à environ 80°C et pendant une durée égale à environ 5 mn. Un deuxième recuit de la couche déposée peut ensuite être mis en oeuvre dans une étuve, à une température égale à environ 150°C et pendant une durée égale à environ 30 mn. Pour améliorer encore la dureté de la couche obtenu, il est possible d'exposer la couche à un rayonnement ultraviolet obtenu par exemple avec un laser à excimère de longueur d'onde égale à 248 nm, sous une fluence comprise entre environ 20 mJ/cm² et 200 mJ/cm², avec des impulsions de durée égale à environ 30 ns, et avec un nombre d'exposition du matériau de la couche au faisceau laser par exemple égal à 5.

Le capteur 100 est ensuite achevé en réalisant les éléments chauffants 114 et la couche d'encapsulation 116. Les éléments chauffants 114 peuvent être réalisés sous la forme de serpentins ou de lignes rectangulaires. Lorsque le matériau de la couche d'encapsulation 116 est déposé de manière localisée, comme par exemple par pulvérisation ou par jet d'encre, la couche d'encapsulation 116 est formée dès le dépôt de manière localisée sur les éléments chauffants 114 et les éventuelles parties de matériau pyroélectrique non recouvertes par les éléments chauffants 114.

Dans les différents exemples décrits précédemment, le capteur de motif thermique 100 est utilisé en tant que détecteur d'empreinte digitale. Toutefois, le capteur 100 peut être utilisé pour former un capteur d'empreinte palmaire, notamment lorsque le capteur 100 a des dimensions importantes et est réalisé par impression sur un substrat souple. Le capteur 100 peut également être adapté pour réaliser une détection de motifs thermiques autres que des empreintes digitales, du fait que chaque pixel 102 du capteur 100 lit la capacité calorifique placée au-dessus de lui et cela quelle que soit la nature du motif thermique.

De plus, le capteur de motif thermique 100 peut également servir à la réalisation d'un imageur infrarouge non refroidi. Les pixels 102 du capteur 100 sont dans ce cas intégrés sur un circuit intégré de type CCD ou CMOS collectant les charges électriques générées par le capteur. Un tel imageur comporte en outre une lentille infrarouge filtrant la lumière arrivant sur le capteur. Afin que le capteur 100 puisse être soumis à une différence de températures (nécessaire compte tenu de la mesure réalisée par les capacités pyroélectriques), l'imageur comporte un dispositif permettant successivement de bloquer la lumière infrarouge arrivant sur le capteur puis de laisser passer cette lumière. Un tel dispositif peut correspondre à un « chopper », c'est-à-dire une roue munie d'un trou et tournant devant le capteur. Un élément absorbeur peut être ajouté sur le matériau pyroélectrique afin d'améliorer l'absorption du rayonnement infrarouge reçu.

## Revendications

1. Capteur (100) de motif thermique comportant plusieurs pixels (102) disposés sur un substrat (104), chaque pixel (102) comprenant au moins :
- une capacité pyroélectrique formée par au moins une portion (106) de matériau pyroélectrique disposée entre au moins une électrode inférieure (108) et au moins une électrode supérieure (110), avec l'électrode inférieure (108) disposée entre le substrat (104) et la portion (106) de matériau pyroélectrique,
- une couche diélectrique (112) telle que l'électrode supérieure (110) soit disposée entre la portion (106) de matériau pyroélectrique et la couche diélectrique (112),
- un élément chauffant (114) comprenant au moins un dépôt de particules électriquement conductrices et tel que la couche diélectrique (112) soit disposée entre l'électrode supérieure (110) et l'élément chauffant (114),
- une couche de protection (200) disposée entre la couche diélectrique (112) et l'élément chauffant (114) et comprenant au moins un matériau dont la dureté Shore A est supérieure ou égale à environ 60.

2. Capteur (100) de motif thermique selon la revendication 1, dans lequel l'épaisseur de la couche de protection (200) est comprise entre environ 100 nm et 600 nm.

3. Capteur (100) de motif thermique selon l'une des revendications précédentes, dans lequel la couche de protection (200) comporte au moins un matériau polymère organique réticulable et/ou au moins un matériau inorganique de type sol-gel et/ou du SOG et/ou un matériau céramique de type sol-gel.

4. Capteur (100) de motif thermique selon la revendication 3, dans lequel le matériau polymère organique réticulable correspond à l'un des matériaux suivants : époxy, polyuréthane, acrylique, et/ou dans lequel le SOG correspond à l'un des matériaux suivants : PMMSQ, MSQ, polyquinoxaline, et/ou dans lequel le matériau inorganique de type sol-gel comporte au moins l'un des composés suivants: Al₂O₃, TiO₂, WO₃, SiO₂.

5. Capteur (100) de motif thermique selon l'une des revendications précédentes, dans lequel l'élément chauffant (114) comporte au moins une couche de particules d'argent.

6. Capteur (100) de motif thermique selon l'une des revendications précédentes, dans lequel :
- le substrat (104) comprend au moins un matériau plastique, et/ou
- les électrodes inférieure et supérieure (108, 110) comportent au moins l'un des matériaux suivants : argent, or, cuivre, nickel, carbone, graphène, polymère conducteur.

7. Capteur (100) de motif thermique selon l'une des revendications précédentes, dans lequel ledit capteur (100) de motif thermique est un capteur d'empreinte digitale.

8. Procédé de réalisation d'un capteur (100) de motif thermique comportant plusieurs pixels (102) disposés sur un substrat (104), chacun réalisé par la mise en oeuvre des étapes suivantes :
- réalisation d'au moins une électrode inférieure (108) sur un substrat (104) ;
- réalisation d'au moins une portion (106) de matériau pyroélectrique au moins sur l'électrode inférieure (108) ;
- réalisation d'au moins une électrode supérieure (110) sur la portion (106) de matériau pyroélectrique ;
- réalisation d'au moins une couche diélectrique (112) au moins sur l'électrode supérieure (110) ;
- réalisation d'au moins une couche de protection (200) sur la couche diélectrique (112) ;
- réalisation d'au moins un élément chauffant (114) sur la couche de protection (200) ;
dans lequel l'électrode inférieure (108), l'électrode supérieure (110) et la portion (106) de matériau pyroélectrique forment une capacité pyroélectrique, et dans lequel la couche de protection (200) comporte un matériau dont la dureté Shore A est supérieure ou égale à environ 60.

9. Procédé selon la revendication 8, dans lequel l'élément chauffant (114) comporte au moins une couche de particules d'argent formée par un dépôt par impression.

10. Procédé selon l'une des revendications 8 et 9, dans lequel l'électrode inférieure (108) et/ou l'électrode supérieure (110) et/ou la portion (106) de matériau pyroélectrique sont réalisées par des dépôts par impression.

11. Procédé selon l'une des revendications 8 à 10, dans lequel ledit capteur (100) de motif thermique est un capteur d'empreinte digitale.
